# EUROPEAN PATENT APPLICATION

(11) **EP 4 727 071 A1**
(43) Date of publication of application: **15.04.2026**
(21) Application number: 25190669.9
(22) Date of filing: 21.07.2025
(51) Int. Cl.: H04L 25/03

(54) **SWITCHED CAPACITOR EQUALIZER USING INTEGRATING AMPLIFIER**

(30) Priority: 08.10.2024 KR 20240136582
(71) Applicant: Korea University Research and Business Foundation, Seoul 02841 (KR)
(72) Inventor: KIM, Chulwoo, 06276 Seoul (KR); So, Junseob, 06767 Seoul (KR); KIMG, Seongcheol, 02566 Seol (KR); SHIN, HWASEOK, 06993 Seoul (KR)
(74) Representative: RGTH

(57) **Abstract**

The present disclosure relates to a switched capacitor equalizer. The switched capacitor equalizer according to some embodiments of the present disclosure may include a first integrating amplifier that integrates input voltage in response to an odd clock period and outputs first output voltage, a second integrating amplifier that integrates the input voltage in response to an even clock period and outputs second output voltage, a coupling capacitor that delivers the first output voltage to the second integrating amplifier in response to the odd clock period and delivers the second output voltage to the first integrating amplifier in response to the even clock period, and a first transistor that outputs an odd data signal in response to the odd clock period, and a second transistor that outputs an even data signal in response to the even clock period.

## Description

### CROSS-REFERENCE TO RELATED APPLICATIONS

This application claims priority to Korean Patent Application No. 10-2024-0136582 filed on October 8, 2024, in the Korean Intellectual Property Office, the disclosures of which are incorporated by reference herein in their entireties.

### BACKGROUND

Embodiments of the present disclosure described herein relate to a switched capacitor equalizer using an integrating amplifier.

Communication between devices or chips may be achieved through an interface. During the communication process, signals may be distorted and transmitted between devices or between chips. To compensate for such the distortion of the signals, the interface may include an equalizer.

The equalizer may perform an operation of generating a plurality of feedback signals and adding the plurality of feedback signals and an input signal through an adder. The adder may receive and add the plurality of feedback signals and the input signal, and may output the added results to a plurality of sense amplifiers. In the case, because the plurality of sense amplifiers, output nodes of the plurality of feedback signals, and the input signal are connected to an input node of the adder, it is difficult to secure sufficient bandwidth of the adder. Accordingly, there is a need for the equalizer capable of simultaneously compensating for noise occurring in a channel and intersymbol interference (ISI).

There is a prior art disclosed as Korean Registered Patent No. 10-0754967 (Patent Document 1).

### SUMMARY

Embodiments of the present disclosure provide a switched capacitor equalizer using an integrating amplifier.

According to an embodiment, a switched capacitor equalizer includes a first integrating amplifier that integrates input voltage in response to an odd clock period and outputs first output voltage, a second integrating amplifier that integrates the input voltage in response to an even clock period and outputs second output voltage, a coupling capacitor that delivers the first output voltage to the second integrating amplifier in response to the odd clock period and delivers the second output voltage to the first integrating amplifier in response to the even clock period, and a first transistor that outputs an odd data signal in response to the odd clock period, and a second transistor that outputs an even data signal in response to the even clock period.

According to some embodiments of the present disclosure, the first integrating amplifier may initialize the input voltage in response to the even clock period.

According to some embodiments of the present disclosure, the second integrating amplifier may initialize the input voltage in response to the odd clock period.

According to some embodiments of the present disclosure, the switched capacitor equalizer may further include a reset timing controller connected to the first transistor and the second transistor and controlling timing.

According to an embodiment, a switched capacitor equalizer includes a first integrating amplifier, of which one end is connected to an input node and of which the other end is connected to a first output node, a second integrating amplifier, of which one end is connected to the input node and of which the other end is connected to a second output node, a coupling capacitor, of which one end is connected to the first output node and of which the other end is connected to the second output node, a first transistor, of which one end is connected to a power supply and of which the other end is connected to the first output node, and a second transistor, of which one end is connected to the power supply and of which the other end is connected to the second output node.

According to some embodiments of the present disclosure, the first integrating amplifier may integrate an input voltage in response to an odd clock period, initialize the input voltage in response to an even clock period, and output first output voltage in response to the odd clock period.

According to some embodiments of the present disclosure, the second integrating amplifier may integrate the input voltage in response to the even clock period, initialize the input voltage in response to the odd clock period, and output second output voltage in response to the even clock period.

According to some embodiments of the present disclosure, the coupling capacitor may deliver the first output voltage to the second integrating amplifier in response to the odd clock period and deliver the second output voltage to the first integrating amplifier in response to the even clock period.

According to some embodiments of the present disclosure, the first transistor may output an odd data signal in response to the odd clock period, and the second transistor may output an even data signal in response to the even clock period.

According to some embodiments of the present disclosure, the switched capacitor equalizer may further include a reset timing controller connected to the first transistor and the second transistor and controlling timing.

### BRIEF DESCRIPTION OF THE FIGURES

The above and other objects and features of the present disclosure will become apparent by describing in detail embodiments thereof with reference to the accompanying drawings.
FIG. 1 is a block diagram of a transceiver according to some embodiments of the present disclosure.
FIG. 2 is a circuit diagram of a switched capacitor equalizer, according to some embodiments of the present disclosure.
FIG. 3 is a circuit diagram of an integrating amplifier, according to some embodiments of the present disclosure.
FIGS. 4A and 4B are timing diagrams for describing an example of an operation of a switched capacitor equalizer, according to some embodiments of the present disclosure.
FIGS. 5A to 5C are circuit diagrams of an integrating amplifier, according to other embodiments of the present disclosure.
FIG. 6 is a circuit diagram further including a reset timing controller, according to other embodiments of the present disclosure.
FIG. 7 is a timing diagram for describing an operation of a reset timing controller, according to other embodiments of the present disclosure.
FIGS. 8A and 8B illustrate simulations of the reset timing controller of FIG. 6.
FIGS. 9A to 9C are block diagrams in which switched capacitor equalizers are connected to each other, according to other embodiments of the present disclosure.
FIGS. 10A and 10B illustrate eye diagrams of input/output voltages, according to some embodiments of the present disclosure.

### DETAILED DESCRIPTION

Hereinafter, embodiments of the present disclosure will be described clearly and in detail with reference to the attached drawings.

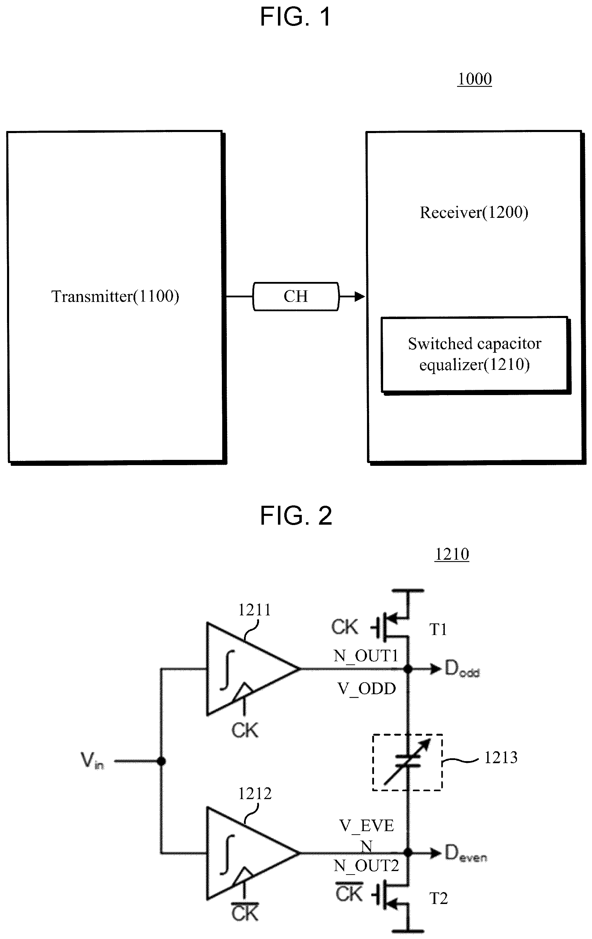

FIG. 1 is a block diagram of a transceiver according to some embodiments of the present disclosure.

A transceiver 1000 according to an embodiment of the present disclosure may be implemented in a device that transmits and receives data. For example, the transceiver 1000 may be implemented in desktop computers, laptop computers, tablet computers, smart phones, wearable devices, and the like where channel interface specifications such as peripheral component interconnection express (PCIe), or PCIe generation (Gen) 6.0 and memory specifications such as Solid State Drive (SSD), embedded universal flash storage (UFS), or double data rate (DDR) are supported.

Referring to FIG. 1, the transceiver 1000 may include a transmitter 1100 and a receiver 1200.

The transmitter 1100 may transmit a signal according to data to the receiver 1200 through a channel CH. The transmitter 1100 may transmit signals including serialized bits of data. For example, the transmitter 1100 may transmit a signal in a single-ended signaling manner.

The channel CH may be a path that physically or electrically connects the transmitter 1100 and the receiver 1200. For example, the channel CH may be implemented by using a trace of a printed circuit board (PCB) or a coaxial cable. A skin effect or a dielectric loss of the channel CH may cause in increase in a high-frequency component of data transmitted over the channel CH. When a signal is conveyed over the channel CH, a channel loss may occur in the receiver 1200. Accordingly, each of bits of data passing through the channel CH may hinder a subsequent bit(s) due to the channel loss or the limitation on a bandwidth, and a phenomenon in which a bit error rate increases due to the overlapping of neighboring symbols, that is, the ISI may occur.

The receiver 1200 may be connected to the transmitter 1100 over the channel CH and may receive a signal transmitted from the transmitter 1100. The receiver 1200 may include a switched capacitor equalizer 1210 to integrate and restore the transmitted signal or to compensate for channel losses.

The switched capacitor equalizer 1210 may amplify an output voltage by integrating and initializing input voltage depending on a period of a clock, and may output a data signal using the amplified output voltage. Detailed descriptions will be given with reference to FIG. 2 below.

FIG. 2 is a circuit diagram of a switched capacitor equalizer, according to some embodiments of the present disclosure.

Referring to FIG. 2, the switched capacitor equalizer 1210 may include a first integrating amplifier 1211, a second integrating amplifier 1212, a coupling capacitor 1213, a first transistor T1, and a second transistor T2.

The first integrating amplifier 1211 may receive input voltage V_IN and may output first output voltage V_ODD. In more detail, the first integrating amplifier 1211 may output the first output voltage V_ODD by integrating or initializing the input voltage V_IN in response to a clock period.

For example, the first integrating amplifier 1211 may output the first output voltage V_ODD, which is obtained by integrating the input voltage V_IN in response to an odd clock period and initializing the input voltage V_IN in response to an even clock period.

To this end, one end of the first integrating amplifier 1211 may be connected to an input node N_IN, and the other end thereof may be connected to a first output node N_OUT1.

The second integrating amplifier 1212 may receive the input voltage V_IN and may output second output voltage V_EVEN. In more detail, the second integrating amplifier 1212 may output the second output voltage V_EVEN by integrating or initializing the input voltage V_IN in response to a clock period.

For example, the second integrating amplifier 1212 may output the second output voltage V_EVEN, which is obtained by integrating the input voltage V_IN in response to the even clock period and initializing the input voltage V_IN in response to the odd clock period.

To this end, one end of the second integrating amplifier 1212 may be connected to the input node N_IN, and the other end thereof may be connected to a second output node N_OUT2.

The coupling capacitor 1213 may repeat charging and discharging in response to a clock period. In other words, the coupling capacitor 1213 may perform compensation by delivering the voltage charged in response to the clock period to the first integrating amplifier 1211 or the second integrating amplifier 1212.

For example, the coupling capacitor 1213 may deliver the first output voltage V_ODD to the second integrating amplifier 1212 at the odd clock period, and may deliver the second output voltage V_EVEN to the first integrating amplifier 1211 at the even clock period.

The first transistor T1 may output a data signal 'D' corresponding to the clock period. For example, the first transistor T1 may output an odd data signal D_ODD in response to an odd clock.

To this end, the first transistor T1 may be a PMOS transistor, and one end of the first transistor T1 may be connected to a power supply VDD, and the other end thereof may be connected to the first output node N_OUT1.

The second transistor T2 may output the data signal 'D' corresponding to the clock period. For example, the second transistor T2 may output an even data signal D_EVEN in response to an even clock.

To this end, the second transistor T2 may be a PMOS transistor, and one end of the second transistor T2 may be connected to the power supply VDD, and the other end thereof may be connected to the second output node N_OUT2.

As described above, the switched capacitor equalizer 1210 according to some embodiments of the present disclosure may eliminate ISI occurring in a channel, thereby reducing an error rate and increasing the transmission speed of data. Furthermore, the switched capacitor equalizer 1210 may provide an equalizer that reduces power consumption by using an integrating amplifier and is robust to noise in a high-frequency band.

Besides, the switched capacitor equalizer 1210 may reduce noise in the low-frequency band by using a signal before demodulation, and may increase the effectiveness and bandwidth of the equalizer by eliminating a delay occurring in a feedback path. In addition, the switched capacitor equalizer 1210 may reduce the size of the equalizer because an additional amplifier is not used.

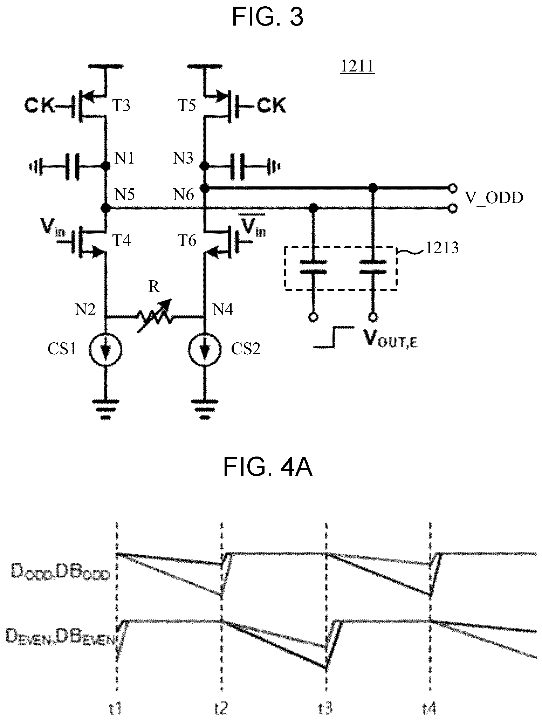

FIG. 3 is a circuit diagram of an integrating amplifier, according to some embodiments of the present disclosure. In detail, only the first integrating amplifier 1211 is described in FIG. 3 as an example, but the second integrating amplifier 1212 may also have the same circuit configuration.

Referring to FIG. 3, the first integrating amplifier 1211 may include third to sixth transistors T3, T4, T5, and T6, load capacitors CL1 and CL2, current sources CS1 and CS2, and a resistor 'R'.

The third transistor T3 may receive a clock CK through a gate terminal. A source terminal of the third transistor T3 may be connected to the power supply VDD, and a drain terminal of the third transistor T3 may be connected to a first node N1. The third transistor T3 may control voltage between the source terminal and the drain terminal depending on the clock CK. Moreover, one end of the first load capacitor CL1 may be connected to ground, and the other end thereof may be connected to the first node N1.

The fourth transistor T4 may receive the input voltage V_IN through a gate terminal. A drain terminal of the fourth transistor T4 may be connected to the first node N1, and a source terminal of the fourth transistor T4 may be connected to a second node N2. The fourth transistor T4 may control the amount of current flowing between the source terminal and the drain terminal depending on the input voltage V_IN. To this end, one end of the first current source CS1 may be connected to the second node N2, and the other end thereof may be connected to the ground.

The fifth transistor T5 may receive the clock CK through a gate terminal. A source terminal of the fifth transistor T5 may be connected to the power supply VDD, and a drain terminal of the fifth transistor T5 may be connected to a third node N3. The fifth transistor T5 may control the voltage between the source terminal and the drain terminal depending on the clock CK. Furthermore, one end of the second load capacitor CL2 may be connected to the ground, and the other end thereof may be connected to the third node N3.

The sixth transistor T6 may receive an inverted input voltage V_INB through a gate terminal. A drain terminal of the sixth transistor T6 may be connected to the third node N3, and a source terminal of the sixth transistor T6 may be connected to a fourth node N4. The sixth transistor T6 may control the amount of current flowing between the source terminal and the drain terminal depending on the inverted input voltage V_INB. To this end, one end of the second current source CS2 may be connected to the fourth node N4, and the other end thereof may be connected to the ground.

Besides, the resistor 'R' may be a variable resistor. One end of the resistor 'R' may be connected to the second node N2, and the other end thereof may be connected to the fourth node N4. The resistor 'R' may be a variable resistor capable of adjusting a resistor value, and may control the output voltage of a circuit or finely adjust the strength of a signal by adjusting the resistor value.

Here, an output path of the first integrating amplifier 1211 may be connected to a fifth node N5 and a sixth node N6 such that the first output voltage V_ODD may be output differentially. Moreover, the coupling capacitor 1213 may be connected to the output path and may be connected to the second integrating amplifier 1212.

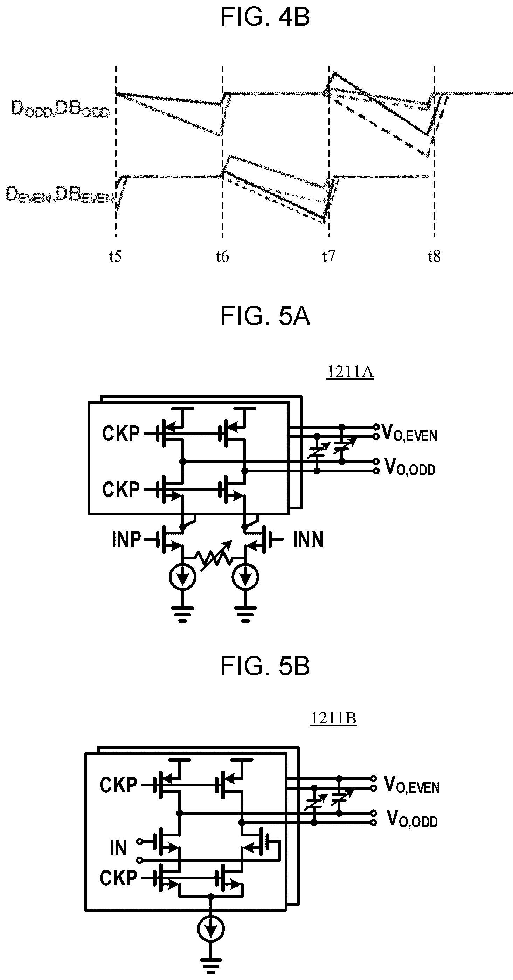

FIGS. 4A and 4B are timing diagrams for describing an example of an operation of a switched capacitor equalizer, according to some embodiments of the present disclosure. In detail, FIG. 4A is a timing diagram showing an example where the coupling capacitor 1213 of the switched capacitor equalizer 1210 is not applied, and FIG. 4B is a timing diagram showing an example where the coupling capacitor 1213 of the switched capacitor equalizer 1210 is applied.

Here, the switched capacitor equalizer 1210 may output the odd data signal D_ODD and an inverted odd data signal DB_ODD by the first output voltage V_ODD that is output differentially. Moreover, the switched capacitor equalizer 1210 may output the even data signal D_EVEN and an inverted even data signal DB_EVEN by the second output voltage V_EVEN that is output differentially.

Referring to FIG. 4A, from a first time point t1 to a second time point t2, the switched capacitor equalizer 1210 may integrate and output the odd data signal D_ODD and the inverted odd data signal DB_ODD in response to an odd clock period. Furthermore, the switched capacitor equalizer 1210 may initialize the even data signal D_EVEN and the inverted even data signal DB_EVEN.

From the second time point t2 to a third time point t3, the switched capacitor equalizer 1210 may integrate and output the even data signal D_EVEN and the inverted even data signal DB_EVEN in response to an even clock period. Furthermore, the switched capacitor equalizer 1210 may initialize the odd data signal D_ODD and the inverted odd data signal DB_ODD.

Here, because the coupling capacitor 1213 is not applied, the switched capacitor equalizer 1210 of FIG. 4A may repeat integration or initialization in response to a clock period from the third time point t3 to a fourth time point t4.

Referring to FIG. 4B, from a fifth time point t5 to a sixth time point t6, the switched capacitor equalizer 1210 may integrate and output the odd data signal D_ODD and the inverted odd data signal DB_ODD in response to the odd clock period. Furthermore, the switched capacitor equalizer 1210 may initialize the even data signal D_EVEN and the inverted even data signal DB_EVEN. Here, the coupling capacitor 1213 may be charged with voltage.

From the sixth time point t6 to the seventh time point t7, the switched capacitor equalizer 1210 may integrate and output the even data signal D_EVEN and the inverted even data signal DB_EVEN in response to the even clock period. Furthermore, the switched capacitor equalizer 1210 may initialize the odd data signal D_ODD and the inverted odd data signal DB_ODD. At this time, an output signal may be prevented from being affected by a previous state by compensating for the voltage charged to the coupling capacitor 1213.

Here, the switched capacitor equalizer 1210 of FIG. 4B may compensate for the voltage charged in response to the clock period from the seventh time point t7 to an eighth time point t8 by using the coupling capacitor 1213, thereby preventing the output signal from being affected by the previous state.

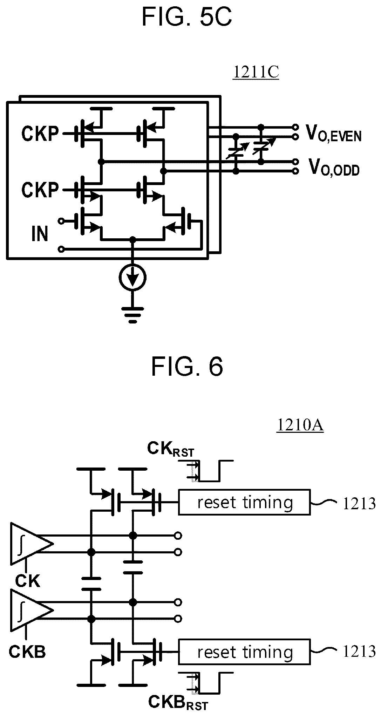

FIGS. 5A to 5C are circuit diagrams of an integrating amplifier, according to other embodiments of the present disclosure. In particular, circuit diagrams of FIGS. 5A to 5C are designed to have the same structure as the first integrating amplifier 1211 of FIGS. 1 to 4B.

FIGS. 5A to 5C are circuit diagrams of the first integrating amplifier 1211 in different methods. All of FIGS. 5A to 5C may be based on the same operating principle and may provide the same functions and effects.

That is, even though each connection method of circuit configurations of FIGS. 5A to 5C is different from a connection method of the first integrating amplifier 1211, each circuit may provide the same functions and effects as the first integrating amplifier 1211. Besides, only the first integrating amplifier 1211 is described in FIGS. 5A to 5C as an example, but the second integrating amplifier 1212 may also have the same circuit configuration.

FIG. 6 is a circuit diagram further including a reset timing controller, according to other embodiments of the present disclosure.

Referring to FIG. 6, a switched capacitor equalizer 1210A may further include a reset timing controller 1214. The reset timing controller 1214 may control the timing at a point in time when a reset signal is generated by a digital circuit. The reset timing controller 1214 may adjust an intermediate state by detecting a time delay that occurs when the clock CK transitions from 0 to 1 or from 1 to 0.

To this end, the reset timing controller 1214 is connected to transistors connected to output the odd data signal D_ODD and the even data signal D_EVEN such that all the transistors do not operate instantaneously.

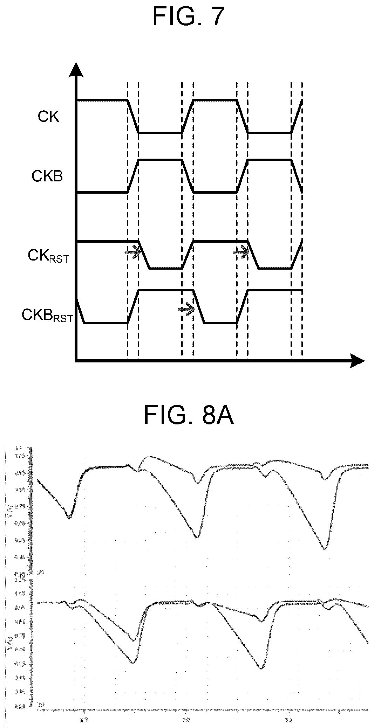

FIG. 7 is a timing diagram for describing an operation of a reset timing controller, according to other embodiments of the present disclosure.

Referring to FIG. 7, the reset timing controller 1214 may delay operations of some transistors by adjusting a reset clock CK_RST and an inverted reset clock CKB_RST.

Accordingly, the reset timing controller 1214 may prevent loss of an initialization signal and may ensure a normal operation of a circuit.

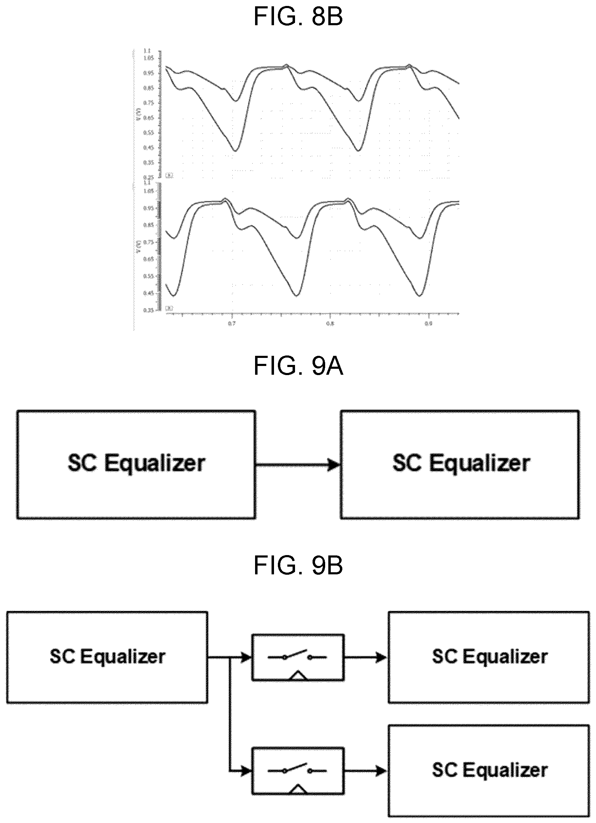

FIGS. 8A and 8B illustrate simulations of the reset timing controller of FIG. 6.

FIG. 8A illustrates a simulation in which the reset timing controller 1214 is not applied. It may be understood that an operation is unstable as the timing is not controlled.

On the other hand, FIG. 8B illustrates a simulation in which the reset timing controller 1214 according to embodiments described in FIG. 6 is applied. It may be understood that the stability of the entire circuit is secured by controlling the timing by a reset signal.

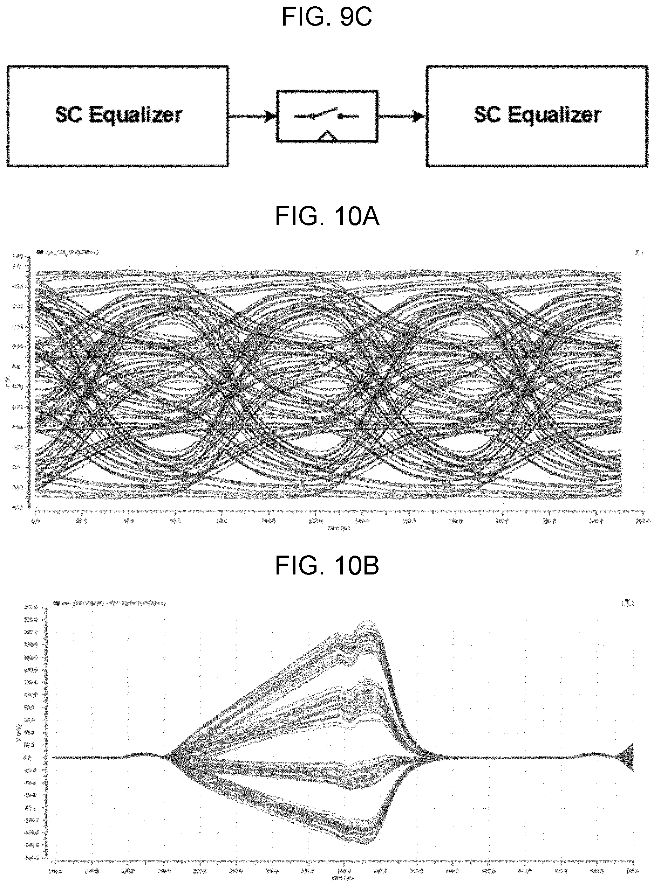

FIGS. 9A to 9C are block diagrams in which switched capacitor equalizers are connected to each other, according to other embodiments of the present disclosure.

Referring to FIGS. 9A to 9C, the switched capacitor equalizer 1210 may be connected to the plurality of switched capacitor equalizers 1210. For example, the switched capacitor equalizer 1210 in a front stage may receive and process the input voltage V_IN, and then may deliver the processed result to the next switched capacitor equalizer 1210. Accordingly, the plurality of switched capacitor equalizers 1210 may additionally amplify or dedicatedly adjust a signal, thereby improving the performance of the receiver 1200.

Moreover, the plurality of switched capacitor equalizers 1210 may include a sample-and-hold circuit between the equalizers. Here, the sample-and-hold circuit may be a circuit that samples a specific instantaneous value of an input signal and maintains the value during a specific time, and may stabilize changes in the signal.

Furthermore, the signal received from the switched capacitor equalizer 1210 in the front stage may be stabilized such that accurate digital conversion is performed.

Accordingly, the plurality of switched capacitor equalizers 1210 may improve the signal quality and may prevent distortion of the entire system.

FIGS. 10A and 10B illustrate eye diagrams of input/output voltages, according to some embodiments of the present disclosure. Hereinafter, the input/output voltage is described by using pulse amplitude modulation-4 level (PAM-4) as an example, but this is only an example and is not limited thereto.

Referring to FIG. 10A, FIG. 10A shows the PAM-4 signal of the input voltage V_IN input from the transmitter 1100. It may be seen that due to the attenuation effect of the channel, the opening of an eye diagram is narrowed and a voltage/time margin is deteriorated.

On the other hand, referring to FIG. 10B, FIG. 10B shows an output voltage outputted through the switched capacitor equalizer 1210 of the PAM-4 signal of the input voltage V_IN inputted to the receiver 1200. It may be seen that the opening of the eye diagram is identified and the voltage/time margin is improved by removing ISI.

The above description refers to detailed embodiments for carrying out the present disclosure. In addition to embodiments described above, the present disclosure may also include embodiments that are capable of being simply redesigned or easily modified. In addition, technologies that are easily changed and implemented by using the above embodiments may be included in the present disclosure. Accordingly, it will be apparent to those of ordinary skill in the art that various changes and modifications may be made to the above embodiments without departing from the spirit and scope of the present disclosure as set forth in the following claims.

A switched capacitor equalizer using an integrating amplifier according to an embodiment of the present disclosure may eliminate intersymbol interference (ISI) occurring in a channel, thereby reducing an error rate and increasing the transmission speed of data. Moreover, the present disclosure may be an equalizer using an integrating amplifier, and may provide an equalizer that is capable of reducing power consumption and is robust to noise in a high-frequency band.

While the present disclosure has been described with reference to embodiments thereof, it will be apparent to those of ordinary skill in the art that various changes and modifications may be made thereto without departing from the spirit and scope of the present disclosure as set forth in the following claims.

This work was supported by the National Research Foundation of Korea (NRF) funded by the Ministry of Science and ICT (MSIT) (No. RS-2023-0281047).

## Claims

1. A switched capacitor equalizer comprising:
a first integrating amplifier configured to integrate input voltage in response to an odd clock period and to output first output voltage;
a second integrating amplifier configured to integrate the input voltage in response to an even clock period and to output second output voltage;
a coupling capacitor configured to deliver the first output voltage to the second integrating amplifier in response to the odd clock period and to deliver the second output voltage to the first integrating amplifier in response to the even clock period; and
a first transistor configured to output an odd data signal in response to the odd clock period; and
a second transistor configured to output an even data signal in response to the even clock period.

2. The switched capacitor equalizer of claim 1, wherein the first integrating amplifier initializes the input voltage in response to the even clock period.

3. The switched capacitor equalizer of claim 2, wherein the second integrating amplifier initializes the input voltage in response to the odd clock period.

4. The switched capacitor equalizer of claim 1, further comprising:
a reset timing controller connected to the first transistor and the second transistor and configured to control timing.

5. A switched capacitor equalizer comprising:
a first integrating amplifier, of which one end is connected to an input node and of which the other end is connected to a first output node;
a second integrating amplifier, of which one end is connected to the input node and of which the other end is connected to a second output node;
a coupling capacitor, of which one end is connected to the first output node and of which the other end is connected to the second output node;
a first transistor, of which one end is connected to a power supply and of which the other end is connected to the first output node; and
a second transistor, of which one end is connected to the power supply and of which the other end is connected to the second output node.

6. The switched capacitor equalizer of claim 5, wherein the first integrating amplifier integrates an input voltage in response to an odd clock period, initializes the input voltage in response to an even clock period, and outputs first output voltage in response to the odd clock period.

7. The switched capacitor equalizer of claim 6, wherein the second integrating amplifier integrates the input voltage in response to the even clock period, initializes the input voltage in response to the odd clock period, and outputs second output voltage in response to the even clock period.

8. The switched capacitor equalizer of claim 7, wherein the coupling capacitor delivers the first output voltage to the second integrating amplifier in response to the odd clock period and delivers the second output voltage to the first integrating amplifier in response to the even clock period.

9. The switched capacitor equalizer of claim 8, wherein the first transistor outputs an odd data signal in response to the odd clock period, and the second transistor outputs an even data signal in response to the even clock period.

10. The switched capacitor equalizer of claim 5, further comprising:
a reset timing controller connected to the first transistor and the second transistor and configured to control timing.
